# EUROPEAN PATENT APPLICATION

(11) **EP 4 770 300 A1**
(43) Date of publication of application: **01.07.2026**
(21) Application number: 24930550.9
(22) Date of filing: 16.12.2024
(51) Int. Cl.: H05K 9/00

(54) **CIRCUIT BOARD ASSEMBLY AND ELECTRONIC DEVICE**

(30) Priority: 18.03.2024 CN 202420531926 U
(71) Applicant: Huawei Digital Power Technologies Co., Ltd., Shenzhen, Guangdong 518129 (CN)
(72) Inventor: HU, Xiaogang, Shenzhen, Guangdong 518129 (CN); ZHU, Guangyao, Shenzhen, Guangdong 518129 (CN); WANG, Tingting, Shenzhen, Guangdong 518129 (CN); LI, Heng, Shenzhen, Guangdong 518129 (CN); YUAN, Dezeng, Shenzhen, Guangdong 518129 (CN); WU, Minjian, Shenzhen, Guangdong 518129 (CN)
(74) Representative: Pfenning, Meinig & Partner mbB
(86) International application number: PCT/CN2024/139661
(87) International publication number: WO 2025/194894

(57) **Abstract**

Embodiments of this application relate to the field of chip technologies, and provide a circuit board assembly and an electronic device. The circuit board assembly includes a circuit board, an electronic component, a shielding structure, and a heat dissipation structure. The electronic component is disposed on the circuit board, the shielding structure is disposed on the circuit board, a through opening is provided at a position that is on the shielding structure and that is opposite to the circuit board, and at least a part of the heat dissipation structure covers the through opening. The heat dissipation structure and the shielding structure form a shielding cover, and the shielding cover covers the electronic component. According to the circuit board assembly provided in this application, when a height of the electronic component is increased, a height of the shielding cover does not need to be increased, thereby reducing the height of the shielding cover, reducing space occupied in the electronic device, and facilitating further thinning of the electronic device. The heat dissipation structure is used as a part of the shielding cover, so that the heat dissipation structure can implement an electromagnetic shielding function for the electronic component while implementing heat dissipation on the electronic component, thereby implementing function diversity of the heat dissipation structure.

## Description

This application claims priority to Chinese Patent Application No. 202420531926.2, filed with the China National Intellectual Property Administration on March 18, 2024 and entitled "CIRCUIT BOARD ASSEMBLY AND ELECTRONIC DEVICE", which is incorporated herein by reference in its entirety.

### TECHNICAL FIELD

This application relates to the field of chip technologies, and in particular, to a circuit board assembly and an electronic device.

### BACKGROUND

With the continuous development of communication technologies, requirements on performance of electronic devices are increasingly high. Excellent operating performance of electronic components in the electronic device is one of important factors for ensuring high performance of the electronic device. However, the electronic components generate mutual electromagnetic interference during operation, affecting operating performance of the electronic components and the electronic device. In addition, heat dissipation performance of the electronic components also affect the operating performance of the electronic components.

In a related technology, to provide a shielding effect for an electronic component, a shielding cover is usually disposed on a circuit board on which the electronic component is disposed. Shielding space is formed between the shielding cover and the circuit board, and an electronic component relatively sensitive to electromagnetic interference is disposed in the shielding space, so that an anti-interference capability of the electronic component in the shielding space can be improved. In addition, a heat dissipation apparatus is disposed on the outside of the shielding cover to dissipate heat of the electronic component.

However, because the shielding cover covers the electronic component, if a height of the electronic component is relatively large, a height of the shielding cover in a thickness direction of the circuit board is relatively large. In combination with a thickness of the heat dissipation apparatus, this results in occupation of relatively large space in the electronic device, restricting further thinning of the electronic device.

### SUMMARY

Embodiments of this application provide a circuit board assembly and an electronic device, to resolve the following technical problem: When a height of an electronic component is relatively large, a height of a shielding cover in a thickness direction of a circuit board is relatively large, and in combination with a thickness of a heat dissipation apparatus, relatively large space in the electronic device is occupied, thereby restricting further thinning of the electronic device.

A first aspect of this application provides a circuit board assembly, including a circuit board, an electronic component, a shielding structure, and a heat dissipation structure. The electronic component is disposed on the circuit board, the shielding structure is disposed on the circuit board, a through opening is provided at a position that is on the shielding structure and that is opposite to the circuit board, and at least a part of the heat dissipation structure covers the through opening. The heat dissipation structure and the shielding structure form a shielding cover, and the shielding cover covers the electronic component.

The circuit board assembly provided in this embodiment of this application includes the electronic component and the shielding structure that are disposed on the circuit board and the circuit board. The through opening is provided at the position that is on the shielding structure and that is opposite to the circuit board. At least the part of the heat dissipation structure covers the through opening, so that the heat dissipation structure and the shielding structure jointly form the shielding cover to cover the electronic component, and a part of a structure that is of the electronic component and that faces the through opening can extend into the through opening to occupy a height of the through opening in a thickness direction of the circuit board. In this way, when a height of the electronic component is increased, a height of the shielding cover does not need to be increased, thereby reducing the height of the shielding cover, reducing space occupied in the electronic device, and facilitating further thinning of the electronic device.

In addition, at least the part of the heat dissipation structure and the shielding structure jointly form the shielding cover, so that the heat dissipation structure and the shielding structure can jointly form the shielding cover to implement an electromagnetic shielding function for the electronic component while the heat dissipation structure implements heat dissipation on the electronic component, thereby implementing function diversity of the heat dissipation structure.

In a possible implementation, the heat dissipation structure includes a metal housing and a heat dissipation medium disposed in the metal housing, at least a part of the metal housing covers the through opening, and the metal housing and the shielding structure form the shielding cover.

The heat dissipation structure includes the metal housing and the heat dissipation medium disposed in the metal housing. Heat generated by the electronic component during operation is transmitted to the heat dissipation medium through the metal housing, thereby implementing heat exchange with the heat dissipation medium. In this way, heat dissipation is performed for the electronic component through the heat dissipation structure. In addition, at least the part of the metal housing covers the through opening, to implement electromagnetic shielding.

In a possible implementation, the heat dissipation structure is a vapor chamber heat dissipator or a liquid-cooling heat dissipator.

The heat dissipation structure is configured as the vapor chamber heat dissipator, so that heat exchange with the electronic component can be implemented by using a vapor chamber. The heat dissipation structure is configured as the liquid-cooling heat dissipator, so that liquid-cooling heat dissipation can be implemented for the electronic component through the liquid-cooling heat dissipator.

In a possible implementation, a first spacing exists between the heat dissipation structure and an end that is of the shielding structure and that faces away from the circuit board.

The first spacing is provided between the heat dissipation structure and the end that is of the shielding structure and that faces away from the circuit board, so that buffer space can be formed between the shielding structure and the heat dissipation structure. This prevents the heat dissipation structure from coming into direct contact with the shielding structure when the heat dissipation structure is displaced toward the shielding structure due to an external force. The first spacing can absorb and disperse impact energy, mitigate transmission of a shock force, and thereby reduce direct damage to the shielding structure caused by the heat dissipation structure.

When the heat dissipation structure is subject to an impact, the spacing provides a buffering effect, to reduce a degree of transmission the impact force to the shielding structure. In this way, a possibility that the shielding structure is damaged can be reduced, and the heat dissipation structure is protected from being damaged. This reduces the impact force exerted by the heat dissipation structure on the shielding structure, reduces a probability of damage to the shielding structure, and improves use stability of the circuit board assembly.

In addition, the first spacing is provided, so that the heat dissipation structure can be prevented from coming into direct contact with the shielding structure, thereby reducing a possibility that heat is conducted to a surface of the shielding structure. This helps prevent the shielding structure from overheating and from thermally affecting the electronic component or another component on the circuit board.

The first spacing is provided between the heat dissipation structure and the shielding structure, so that space for flowing of an airflow can further be provided between the heat dissipation structure and the shielding structure, and an airflow can freely flow between the heat dissipation structure and the shielding structure. This helps improve a heat dissipation effect and increase heat dissipation efficiency of the electronic component.

In a possible implementation, the first spacing is greater than 0 mm and less than or equal to 0.05 mm.

A size of the first spacing in the thickness direction of the circuit board is set to greater than 0 mm and less than or equal to 0.05 mm, so that it can be ensured that buffer space is formed between the heat dissipation structure and the shielding structure, and a problem that a shielding effect of the shielding cover formed by the heat dissipation structure and the shielding structure is relatively poor due to an excessively large size of the first spacing can further be avoided.

In a possible implementation, the heat dissipation structure is connected to the circuit board through a fastener.

The heat dissipation structure is connected to the circuit board through the fastener, so that stability of disposing the heat dissipation structure on the circuit board can be improved, and stability of a connection between the circuit board and the heat dissipation structure can be improved, thereby improving structural stability of the circuit board assembly.

In a possible implementation, the circuit board assembly further includes an elastic shielding member, the elastic shielding member is disposed on an outer peripheral side of the shielding structure, one end of the elastic shielding member is connected to the circuit board or the shielding structure, and the other end of the elastic shielding member is pressed tightly against the heat dissipation structure.

The circuit board assembly includes the elastic shielding member, the elastic shielding member is disposed on the outer peripheral side of the shielding structure, and the one end that is of the shielding structure and that faces away from the circuit board is pressed tightly against the heat dissipation structure, so that the first spacing between the heat dissipation structure and the shielding structure can be closed, an electromagnetic wave emitted by the electronic component in the shielding structure is prevented from leaking from the first spacing, and a shielding effect of the shielding cover formed by the shielding structure and the heat dissipation structure is improved.

In a possible implementation, in a thickness direction of the circuit board, a height of the elastic shielding member is greater than a height of the shielding structure; and in the thickness direction of the circuit board, a compression amount of the elastic shielding member is greater than or equal to 40%.

The height of the elastic shielding member is greater than the height of the shielding structure, so that when the heat dissipation structure and the elastic shielding member are pressed tightly, the elastic shielding member can generate the compression amount, and the elastic shielding member can have an elastic recovery force after being pressed, and is pressed tightly against the heat dissipation structure under an action of the elastic recovery force, thereby improving contact tightness between the heat dissipation structure and the elastic shielding member, and improving a shielding effect of the shielding cover.

In a possible implementation, a second spacing exists between the elastic shielding member and the shielding structure.

The second spacing is provided between the elastic shielding member and the shielding structure, so that the elastic shielding member can be easily disassembled and maintained.

In addition, the second spacing is provided, so that a probability that the shielding structure is deformed because the shielding structure is squeezed because the elastic shielding member is tilted toward the shielding structure in a compression deformation process can be avoided, thereby further reducing a probability that the electronic component is damaged or a shielding effect is affected due to deformation of the shielding structure, and improving use stability of the circuit board assembly.

In a possible implementation, the elastic shielding member is an elastic shielding member prepared by using conductive foam.

The elastic shielding member is configured as the elastic shielding member prepared by using the conductive foam. Because the conductive foam has good electrical conductivity, an electromagnetic wave at the first spacing can be effectively shielded, electromagnetic wave leakage at the first spacing is reduced, and an anti-interference capability of the electronic component is improved.

In addition, the conductive foam has softness and elasticity, and can provide a good buffering and protection effect, so that the shielding structure and the electronic component are less affected by vibration and a shock that are generated when the heat dissipation structure is subject to an impact.

In addition, the conductive foam has relatively good thermal conductivity, thereby facilitating conduction and dissipation of heat generated by the electronic device during operation, and helping maintain operating stability of the electronic component.

The conductive foam has good processability and cutting performance, and can be customized as required. The conductive foam is applicable to assembly requirements of various shapes and sizes, thereby improving processing flexibility and practicability of the elastic shielding member and reducing manufacturing costs of an elastic conductive member.

In a possible implementation, the circuit board assembly further includes an insulation layer, the insulation layer is disposed on a side that is of the heat dissipation structure and that faces the electronic component, and at least a part of the insulation layer covers the through opening.

The circuit board assembly includes the insulation layer, the insulation layer is disposed on the side that is of the heat dissipation structure and that faces the electronic component, and at least the part of the insulation layer covers the through opening, so that electrical contact between the heat dissipation structure and the electronic component can be avoided, and operating stability of the electronic component is improved.

In a possible implementation, the insulation layer is a polyethylene terephthalate layer or a polyimide layer.

The insulation layer is configured as the polyethylene terephthalate layer or the polyimide layer, so that an insulation effect between the heat dissipation structure and the electronic component can be improved, electrical contact between the heat dissipation structure and the electronic component can be avoided, and operating stability of the electronic component can be improved.

In a possible implementation, the shielding structure includes a shielding frame, the shielding frame has the through opening, the shielding frame surrounds an outer peripheral side of the electronic component, the shielding frame is connected to the circuit board, and the heat dissipation structure covers the through opening.

The shielding structure includes the shielding frame, and the shielding frame is disposed on the outer peripheral side of the electronic component, to perform electromagnetic shielding on the electronic component on the peripheral side of the electronic component, and to perform electromagnetic shielding on the electronic component at the through opening by using a part of the heat dissipation structure.

In a possible implementation, a side that is of the shielding frame and that faces the circuit board is provided with a first flange, the first flange surrounds an outer peripheral side of the shielding frame, and the shielding frame is connected to the circuit board through the first flange.

The first flange provided on the outer peripheral side of the shielding frame is provided on the side that is of the shielding frame and that faces the circuit board, and the shielding frame is enabled to be connected to the circuit board through the first flange, so that a contact area between the shielding frame and the circuit board can be increased, thereby improving stability of a connection between the shielding frame and the circuit board.

In a possible implementation, an end that is of the shielding frame and that faces away from the circuit board is provided with a second flange, and an inner edge of the second flange encloses the through opening.

The second flange is provided at the end that is of the shielding frame and that faces away from the circuit board, and the inner edge of the second flange encloses the through opening, so that when the heat dissipation structure is subject to an impact toward the shielding structure, the heat dissipation structure comes into contact with the shielding frame through the second flange, thereby increasing a contact area between the heat dissipation structure and the shielding frame, reducing damage to the heat dissipation structure caused by the shielding frame due to an excessively small contact area between the heat dissipation structure and the shielding frame, and prolonging a service life of the heat dissipation structure.

A second aspect of this application provides an electronic device, including a rear housing and the foregoing circuit board assembly. The circuit board assembly is disposed in the rear housing; and the heat dissipation structure in the circuit board assembly is connected to the circuit board in the circuit board assembly through the fastener; a heat dissipation structure is connected to the rear housing; or a heat dissipation structure is connected to both the rear housing and a circuit board.

According to the electronic device provided in this embodiment of this application, the circuit board assembly is disposed in the rear housing, a through opening is provided at a position that is on a shielding structure of the circuit board assembly and that is opposite to the circuit board, and the heat dissipation structure in the circuit board assembly and the shielding structure jointly form a shielding cover to cover an electronic component, so that when a height of the electronic component is increased, a height of the shielding cover does not need to be increased, thereby reducing the height of the shielding cover, and facilitating a lightness and thinning design of the electronic device.

In addition, at least a part of the heat dissipation structure and the shielding structure jointly form the shielding cover, so that the heat dissipation structure and the shielding structure can jointly form the shielding cover to implement an electromagnetic shielding function for the electronic component while the heat dissipation structure implements heat dissipation on the electronic component, thereby implementing function diversity of the heat dissipation structure.

A third aspect of this application provides an electronic device, including a rear housing, a circuit board, an electronic component, and a shielding structure. The electronic component is disposed on the circuit board, the shielding structure is disposed on the circuit board, and a through opening is provided at a position that is on the shielding structure and that is opposite to the circuit board. At least a part of the rear housing covers the through opening, the part of the rear housing and the shielding structure form a shielding cover, and the shielding cover covers the electronic component.

The through opening is provided at the position that is on the shielding structure and that is opposite to the circuit board, so that a part of the electronic component can extend into the through opening, and when a height of the electronic component is increased, a height of the shielding cover does not need to be increased. In addition, a part of the rear housing is used to cover the through opening on the shielding structure, so that a part of the rear housing and the shielding structure jointly form the shielding cover to cover the electronic component, and using another shielding member to cover the through opening can be avoided. In this case, a distance between the through opening and the rear housing can be reduced, thereby further reducing internal space of the electronic device occupied by the circuit board assembly, and facilitating further thinning of the electronic device.

In a possible implementation, the circuit board assembly further includes an elastic shielding member, the elastic shielding member is disposed on an outer peripheral side of the shielding structure, one end of the elastic shielding member is connected to the circuit board or the shielding frame, and the other end of the elastic shielding member is pressed tightly against an inner wall of the rear housing.

The elastic shielding member is disposed on the outer peripheral side of the shielding structure, so that the one end of the elastic shielding member is connected to the circuit board or the shielding frame, and the other end of the elastic shielding member is pressed tightly against the inner wall of the rear housing, so that an electromagnetic wave leaked from a gap between the rear housing and the shielding structure can be shielded by using the elastic shielding member, thereby improving shielding performance of the shielding cover.

In a possible implementation, in a thickness direction of the circuit board, a height of the elastic shielding member is greater than a height of the shielding structure; and in the thickness direction of the circuit board, a compression amount of the elastic shielding member is greater than or equal to 40%.

The height of the elastic shielding member is greater than the height of the shielding structure, so that when the rear housing and the elastic shielding member are pressed tightly, the elastic shielding member can generate the compression amount, and the elastic shielding member can have an elastic recovery force after being pressed, and is pressed tightly against the rear housing under an action of the elastic recovery force, thereby improving contact tightness between the rear housing and the elastic shielding member, and improving a shielding effect of the shielding cover.

In a possible implementation, a second spacing exists between the elastic shielding member and the shielding frame.

The second spacing is provided between the elastic shielding member and the shielding structure, so that the elastic shielding member can be easily disassembled and maintained.

In addition, the second spacing is provided, so that a probability that the shielding structure is deformed because the shielding structure is squeezed because the elastic shielding member is tilted toward the shielding structure in a compression deformation process can be avoided, thereby further reducing a probability that the electronic component is damaged or a shielding effect is affected due to deformation of the shielding structure, and improving use stability of the electronic device.

In a possible implementation, the elastic shielding member is an elastic shielding member prepared by using conductive foam.

The elastic shielding member is configured as the elastic shielding member prepared by using the conductive foam. Because the conductive foam has good electrical conductivity, an electromagnetic wave at the first spacing can be effectively shielded, electromagnetic wave leakage at the first spacing is reduced, and an anti-interference capability of the electronic component is improved.

### BRIEF DESCRIPTION OF DRAWINGS

FIG. 1 is a diagram of a structure of an electronic device according to an embodiment of this application;
FIG. 2 is an exploded view of an electronic device according to an embodiment of this application;
FIG. 3 is a diagram of a structure of a circuit board assembly in a related technology;
FIG. 4A is an exploded view of a circuit board assembly according to an embodiment of this application;
FIG. 4B is a cross-sectional diagram of a circuit board assembly according to an embodiment of this application;
FIG. 5 is a cross-sectional diagram of a second circuit board assembly according to an embodiment of this application;
FIG. 6 is a cross-sectional diagram of a third circuit board assembly according to an embodiment of this application;
FIG. 7 is a cross-sectional diagram of a fourth circuit board assembly according to an embodiment of this application;
FIG. 8 is a cross-sectional diagram of a fifth circuit board assembly according to an embodiment of this application;
FIG. 9 is a cross-sectional diagram of a sixth circuit board assembly according to an embodiment of this application; and
FIG. 10 is a cross-sectional diagram of a seventh circuit board assembly according to an embodiment of this application.

Descriptions of reference numerals:
10: circuit board assembly; 20: display screen; 30: rear housing; 40: middle frame;
100: circuit board; 200: electronic component;
300: shielding structure;
310: through opening; 320: first spacing; 330: second spacing; 340: shielding frame; 350: first flange; 360: second flange;
400: heat dissipation structure; 410: metal housing;
500: fastener; 600: elastic shielding member; 700: insulation layer;
10a: circuit board assembly; 100a: circuit board; 200a: electronic component; 300a: shielding cover; 400a: heat dissipation apparatus.

### DESCRIPTION OF EMBODIMENTS

An embodiment of this application provides an electronic device. The electronic device includes but is not limited to a mobile or fixed terminal having a circuit board assembly, such as a mobile phone (such as a bar-type mobile phone or a foldable mobile phone), a tablet computer, a notebook computer, an ultra-mobile personal computer (ultra-mobile personal computer, UMPC for short), a handheld computer, an intercom, a netbook, a POS machine, a personal digital assistant (personal digital assistant, PDA for short), a wearable device (for example, a smart watch (smart watch), a smart wristband (smart wristband), or a pedometer (pedometer)), or a virtual reality device.

In this embodiment of this application, an example in which the foregoing electronic device is a mobile phone is used for description. The mobile phone may be a foldable mobile phone, a bar-type mobile phone, or a slide mobile phone. The following uses the bar-type mobile phone as an example for specific description.

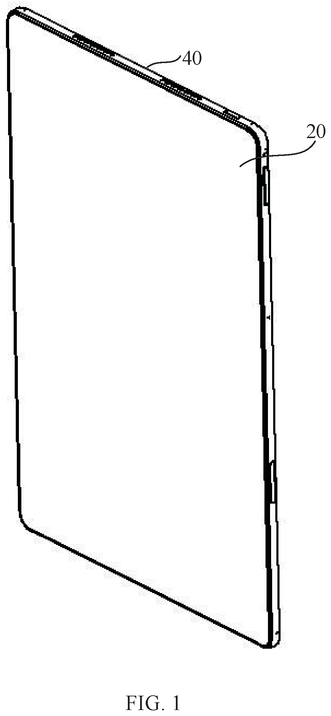

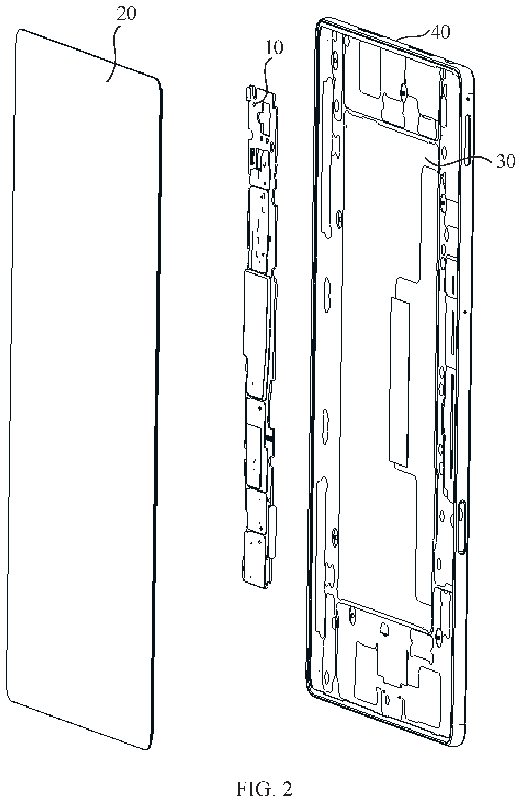

FIG. 1 is a three-dimensional diagram of an electronic device according to this application. FIG. 2 is an exploded diagram of an electronic device according to this application.

As shown in FIG. 1 and FIG. 2, the electronic device may include a display screen 20, a rear housing 30, a middle frame 40, and a circuit board assembly 10. The middle frame 40 is located between the display screen 20 and the rear housing 30. The rear housing 30 may be made of a metal material, such as aluminum, an aluminum alloy, or an aluminum-magnesium alloy.

As shown in FIG. 2, the circuit board assembly 10 may be disposed on the display screen 20. For example, the circuit board assembly 10 may be disposed on a surface that is of the display screen 20 and that faces the rear housing 30, and the circuit board assembly 10 may further be connected to the rear housing 30.

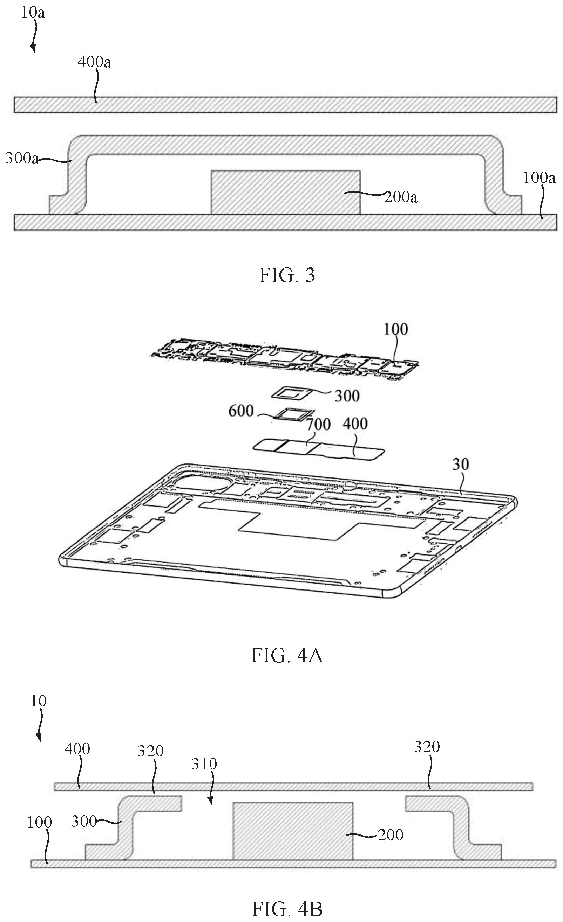

FIG. 3 is a cross-sectional diagram of a circuit board assembly in a related technology.

With the development of lightness and thinning of the electronic device, one of main factors that restrict a thickness of the electronic device is that a relatively thick electronic component 200a relatively sensitive to electromagnetic interference is disposed on a circuit board assembly 10a, and the electronic component 200a includes but is not limited to a mainboard system on chip (system on a chip, SoC). A thickness of a position area of the electronic component 200a is relatively greater than that of another area, which is not conducive to overall thinning of the electronic device.

As shown in FIG. 3, a main reason for this problem is that in a conventional technology, the electronic component 200a is disposed on a circuit board 100a, a shielding cover 300a covers the electronic component 200a, and a heat dissipation apparatus 400a is disposed on a side that is of the shielding cover 300a and that faces away from the circuit board 100a, and is spaced apart from the shielding cover 300a. Electromagnetic shielding can be implemented on the electronic component 200a by disposing the shielding cover 300a, and heat dissipation can be implemented for the electronic component 200a by disposing the heat dissipation apparatus 400a.

When the shielding cover 300a and the heat dissipation apparatus 400a in the conventional technology, in FIG. 3 are used, as a thickness of the electronic component 200a is increased, a height of the shielding cover 300a in a thickness direction is also increased, to cover the electronic component 200a whose thickness is increased. Because a thickness of the shielding cover 300a is increased, in combination with a thickness of the heat dissipation apparatus 400a, a thickness of the circuit board assembly 10a in an area of the electronic component 200a is increased, and relatively large space in the electronic device in the thickness direction is occupied, thereby restricting further thinning of the electronic device.

As shown in FIG. 4A and FIG. 4B, for the foregoing technical problem, this application provides a circuit board assembly 10 and an electronic device. The circuit board assembly 10 includes a circuit board 100, an electronic component 200, a shielding structure 300, and a heat dissipation structure. The electronic component 200 is disposed on the circuit board 100, the shielding structure 300 is disposed on the circuit board 100, a through opening 310 is provided at a position that is on the shielding structure 300 and that is opposite to the circuit board 100, and at least a part of the heat dissipation structure covers the through opening 310. The heat dissipation structure and the shielding structure 300 form a shielding cover, and the shielding cover covers the electronic component 200.

The circuit board assembly 10 provided in this embodiment of this application includes the electronic component 200 and the shielding structure 300 that are disposed on the circuit board 100 and the circuit board 100. The through opening 310 is provided at the position that is on the shielding structure 300 and that is opposite to the circuit board 100. At least the part of the heat dissipation structure covers the through opening 310, so that the heat dissipation structure and the shielding structure 300 jointly form the shielding cover to cover the electronic component 200, and a part of a structure that is of the electronic component 200 and that faces the through opening 310 can extend into the through opening 310 to occupy a height of the through opening 310 in a thickness direction of the circuit board 100. In this way, when a height of the electronic component 200 is increased, a height of the shielding cover does not need to be increased, thereby reducing the height of the shielding cover, reducing space occupied in the electronic device, and facilitating further thinning of the electronic device.

In addition, at least the part of the heat dissipation structure and the shielding structure 300 jointly form the shielding cover, so that the heat dissipation structure and the shielding structure 300 can jointly form the shielding cover to implement an electromagnetic shielding function for the electronic component 200 while the heat dissipation structure implements heat dissipation on the electronic component 200, thereby implementing function diversity of the heat dissipation structure.

To make the foregoing objects, features, and advantages of the embodiments of this application clearer and easier to understand, the technical solutions in the embodiments of this application are described below clearly and completely with reference to the accompanying drawings in the embodiments of this application. It is clear that the described embodiments are merely a part rather than all of embodiments of this application. All other embodiments obtained by persons of ordinary skill in the art based on embodiments of this application without creative efforts shall fall within the protection scope of this application.

As shown in FIG. 4A and FIG. 4B, this application may provide a circuit board assembly. The circuit board assembly may include a circuit board 100, an electronic component 200, a shielding structure 300, and a heat dissipation structure 400. The electronic component 200 is disposed on the circuit board 100, the shielding structure 300 is disposed on the circuit board 100, a through opening 310 is provided at a position that is on the shielding structure 300 and that is opposite to the circuit board 100, and at least a part of the heat dissipation structure 400 covers the through opening 310. The heat dissipation structure 400 and the shielding structure 300 form a shielding cover, and the shielding cover covers the electronic component 200. Based on a disposition orientation in FIG. 4B, the through opening 310 is located above the electronic component 200 disposed on the circuit board 100.

The circuit board assembly may have a plurality of electronic components 200. Some electronic components 200 are relatively sensitive to electromagnetic interference and operating performance of the electronic component 200 is affected. For example, the electronic component 200 may be a memory device, a central processing unit, or a system on chip (system on chip, SoC). However, the shielding cover is disposed on the electronic component 200, so that the electronic component 200 can be effectively shielded from electromagnetic interference, to ensure operating performance of the electronic component 200.

In the shielding cover that includes the shielding structure 300 and at least the part of the heat dissipation structure 400, the shielding structure 300 can perform electromagnetic shielding on a peripheral side of the electronic component 200, and a part that is of the heat dissipation structure 400 and that covers the through opening 310 can shield an electromagnetic wave at the through opening 310, so that the electronic component 200 can be shielded from electromagnetic interference.

In some embodiments, the shielding structure 300 may be a shielding structure 300 made of a conductive material, such as conductive ceramic or metal. During specific implementation, the shielding structure 300 may be a shielding structure 300 made of a metal material. The shielding structure 300 may be connected to the circuit board 100 through welding or bonding by using a conductive adhesive. Compared with the manner of performing bonding by using the conductive adhesive, connecting the shielding structure 300 to the circuit board 100 through welding can improve stability of a connection between the shielding structure 300 and the circuit board 100, and can improve an electromagnetic shielding capability of the connection between the circuit board 100 and the shielding structure 300, thereby preventing electromagnetic interference from affecting, through the connection between the circuit board 100 and the shielding structure 300, the electronic component 200 covered by the shielding structure 300.

In some embodiments, a part of a structure that is of the heat dissipation structure 400 and that covers at least the through opening 310 is a conductive structure, or a side that is of the heat dissipation structure 400 and that faces the through opening 310 is a conductive structure, or an external structure of the heat dissipation structure 400 is a conductive structure as a whole. For example, the conductive structure may alternatively be a metal structure.

In some examples, a metal material for preparing the heat dissipation structure 400 is the same as a metal material for preparing the shielding structure 300. The heat dissipation structure 400 can directly cover the through opening 310, and the heat dissipation structure 400 is connected to an area that is on the shielding structure 300 and that is close to the through opening 310. For example, the heat dissipation structure 400 can be connected to the shielding structure 300 by using a conductive adhesive. Alternatively, the heat dissipation structure 400 and the shielding structure 300 can be spaced apart, to form a buffer zone between the heat dissipation structure 400 and the shielding structure 300, and prevent the heat dissipation structure 400 from directly squeezing the shielding structure 300 when being subject to an impact toward the shielding structure 300, thereby reducing a probability that the shielding structure 300 is damaged.

In some embodiments, the electronic component 200 can be completely located in the shielding cover, or a part of a structure of the electronic component 200 can extend into the through opening 310, so that the electronic component 200 can use a height of the through opening 310 in a thickness direction of the circuit board 100. Therefore, when a height of the electronic component 200 is increased and does not exceed the height of the through opening 310, a height of the shielding structure 300 in the thickness direction of the circuit board 100 does not need to be increased.

It should be noted that a size of the through opening 310 can be set to allow at least the electronic component 200 to pass through, so that a part that is of the electronic component 200 and that faces the through opening 310 can extend into the through opening 310.

In some embodiments, the heat dissipation structure 400 can be connected to the circuit board 100. For example, the heat dissipation structure 400 can be connected to the circuit board 100 by using a threaded connector. The heat dissipation structure 400 can further be connected to a rear housing 30 of an electronic device that uses the circuit board assembly. For example, the heat dissipation structure 400 can be connected to the rear housing 30 by using an adhesive.

In some embodiments, there is a specific spacing between the heat dissipation structure 400 and the electronic component 200, so that the heat dissipation structure 400 can be prevented from coming into direct contact with the electronic component 200, and damage to the electronic component 200 caused by the heat dissipation structure 400 can be avoided.

Based on the circuit board assembly provided in this embodiment of this application, the through opening 310 is provided at the position that is on the shielding structure 300 and that is opposite to the circuit board 100. At least the part of the heat dissipation structure 400 covers the through opening 310, so that the heat dissipation structure 400 and the shielding structure 300 jointly form the shielding cover to cover the electronic component 200, and a part of the structure of the electronic component 200 extends into the through opening 310. In this way, when the height of the electronic component 200 is increased, a height of the shielding cover does not need to be increased, thereby reducing the height of the shielding cover, reducing space occupied in the electronic device, and facilitating further thinning of the electronic device.

In addition, at least the part of the heat dissipation structure 400 and the shielding structure 300 jointly form the shielding cover, so that the heat dissipation structure 400 and the shielding structure 300 can jointly form the shielding cover to implement an electromagnetic shielding function for the electronic component 200 while the heat dissipation structure implements heat dissipation on the electronic component 200, thereby implementing function diversity of the heat dissipation structure 400.

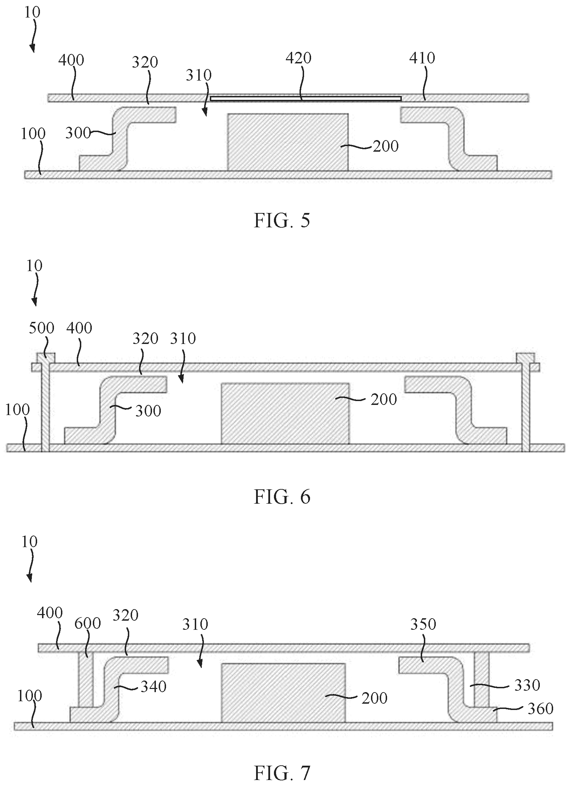

As shown in FIG. 5, in some embodiments, the heat dissipation structure 400 may include a metal housing 410 and a heat dissipation medium disposed in metal housing 410, at least a part of the metal housing 410 covers the through opening 310, and the metal housing 410 and the shielding structure 300 form the shielding cover. The metal housing 410 of the heat dissipation structure 400 has a cavity 420, and the heat dissipation medium can be disposed in the cavity 420.

The heat dissipation structure 400 may include the metal housing 410 and the heat dissipation medium disposed in the metal housing 410. Heat generated by the electronic component 200 during operation is transmitted to the heat dissipation medium through the metal housing 410, thereby implementing heat exchange with the heat dissipation medium. In this way, heat dissipation is performed for the electronic component 200 through the heat dissipation structure 400.

In addition, at least the part of the metal housing 410 covers the through opening 310, so that at least a part of a structure of the metal housing 410 and the shielding structure 300 form the shielding cover to implement electromagnetic shielding.

In some embodiments, the metal housing 410 can be connected to the circuit board 100, or the metal housing 410 can be connected to the rear housing 30 of the electronic device on which the circuit board assembly is installed.

In a possible implementation, the heat dissipation structure 400 is a vapor chamber heat dissipator or a liquid-cooling heat dissipator.

The heat dissipation structure 400 is configured as the vapor chamber heat dissipator, so that heat exchange with the electronic component 200 can be implemented through the vapor chamber heat dissipator. The heat dissipation structure 400 is configured as the liquid-cooling heat dissipator, so that liquid-cooling heat dissipation can be implemented for the electronic component 200 through the liquid-cooling heat dissipator.

In an example, the vapor chamber heat dissipator may use a vapor chamber (vapor chamber, VC) heat dissipation technology. The heat dissipation structure 400 may include a vacuum-sealed chamber filled with an operating fluid (usually liquid metal or another thermally conductive material). When a heat source acts on a side of the heat dissipator, the operating fluid evaporates and transmits heat in the vacuum chamber. Vapor condenses into liquid in a cooling area, and releases heat, which is conducted to an external environment through a wall surface of a heat pipe.

The vapor chamber heat dissipator has advantages of high thermal conductivity, good thermal uniformity, a simple structure, high reliability, and the like. This heat dissipation technology can help the electronic component 200 maintain a stable operating temperature, thereby improving performance and reliability.

The liquid-cooling heat dissipator may be a liquid-cooling plate heat dissipator, with cooling liquid (usually water or another coolant) flowing through a pipe or a channel inside a liquid-cooling plate. When a heat source acts on a surface of the heat dissipator, the cooling liquid absorbs heat through the pipe, then takes away the heat, and finally dissipates the heat through a surface of the liquid-cooling plate.

As shown in FIG. 5, in some embodiments, a first spacing 320 may exist between the heat dissipation structure 400 and an end that is of the shielding structure 300 and that faces away from the circuit board 100.

The first spacing 320 is provided between the heat dissipation structure 400 and the end that is of the shielding structure 300 and that faces away from the circuit board 100, so that buffer space can be formed between the shielding structure 300 and the heat dissipation structure 400. This prevents the heat dissipation structure 400 from coming into direct contact with the shielding structure 300 when the heat dissipation structure 400 is displaced toward the shielding structure 300 due to an external force. The first spacing 320 can absorb and disperse impact energy, mitigate transmission of an impact force, and thereby reduce direct damage to the shielding structure 300 caused by the heat dissipation structure 400.

When the heat dissipation structure 400 is subject to an impact, the spacing provides a buffering effect, allowing the heat dissipation structure 400 to have a longer deformation distance for energy absorption and consequently reducing a degree to which an impact force is transmitted to the shielding structure 300. In this way, a possibility that the shielding structure 300 is damaged can be reduced, and the heat dissipation structure 400 is protected from being damaged. This reduces the impact force exerted by the heat dissipation structure 400 on the shielding structure 300, reduces a probability of damage to the shielding structure 300, and improves use stability of the circuit board assembly.

In addition, the first spacing 320 is provided, so that the heat dissipation structure 400 can be prevented from coming into direct contact with the shielding structure 300, thereby reducing a possibility that heat is conducted to a surface of the shielding structure 300. This helps prevent the shielding structure 300 from overheating and from thermally affecting the electronic component 200 or another component on the circuit board 100.

The first spacing 320 is provided between the heat dissipation structure 400 and the shielding structure 300, so that space for flowing of an airflow can further be provided between the heat dissipation structure 400 and the shielding structure 300, and an airflow can freely flow between the heat dissipation structure 400 and the shielding structure 300. This helps improve a heat dissipation effect and increase heat dissipation efficiency of the electronic component 200.

As shown in FIG. 5, in an example embodiment, the first spacing 320 is greater than 0 mm and less than or equal to 0.05 mm. For example, the first spacing 320 may be 0.01 mm, 0.02 mm, 0.03 mm, or 0.04 mm.

A size of the first spacing 320 in the thickness direction of the circuit board 100 is set to greater than 0 mm and less than or equal to 0.05 mm, so that it can be ensured that buffer space is formed between the heat dissipation structure 400 and the shielding structure 300, and a problem that a shielding effect of the shielding cover formed by the heat dissipation structure 400 and the shielding structure 300 is relatively poor due to an excessively large size of the first spacing 320 can further be avoided.

If the first spacing 320 is excessively large, for example, the first spacing 320 is 0.07 mm, a sum of a height of the heat dissipation structure 400, the height of the shielding structure 300, and the height of the electronic component 200 in the thickness direction of the circuit board 100 is excessively large. This is not conducive to further thinning of the electronic device.

As shown in FIG. 6, in some embodiments, the heat dissipation structure 400 is connected to the circuit board 100 through a fastener 500.

The heat dissipation structure 400 is connected to the circuit board 100 through the fastener 500, so that stability of disposing the heat dissipation structure 400 on the circuit board 100 can be improved, and stability of a connection between the circuit board 100 and the heat dissipation structure 400 can be improved, thereby improving structural stability of the circuit board assembly.

In some embodiments, the fastener 500 may be a long screw. The heat dissipation structure 400 and the circuit board 100 have corresponding threaded holes, and the long screw passes through the threaded holes on the heat dissipation structure 400 and the circuit board 100 at a time, so that the heat dissipation structure 400 and the circuit board 100 are securely connected by using the long screw.

In some embodiments, the circuit board assembly further includes a support structure (not shown in the figure). The support structure is disposed between the circuit board 100 and the heat dissipation structure 400. When the heat dissipation structure 400 is connected to the circuit board 100, the support structure can support the heat dissipation structure 400, thereby further improving stability of a connection between the heat dissipation structure 400 and the circuit board 100, and avoiding shaking after the heat dissipation structure 400 is connected to the circuit board 100.

As shown in FIG. 2 and FIG. 6, based on the foregoing embodiments, when the circuit board assembly in this application is disposed in the electronic device, the heat dissipation structure 400 in the circuit board assembly can be connected to the circuit board 100 in the circuit board assembly through the fastener 500. Alternatively, the heat dissipation structure 400 can be connected to the rear housing 30. Alternatively, when the heat dissipation structure 400 is connected to the rear housing 30, the heat dissipation structure 400 can further be connected to the circuit board 100.

When the heat dissipation structure 400 is connected to the rear housing 30, the heat dissipation structure 400 is further connected to the circuit board 100, so that stability of a connection of the heat dissipation structure 400 can be improved.

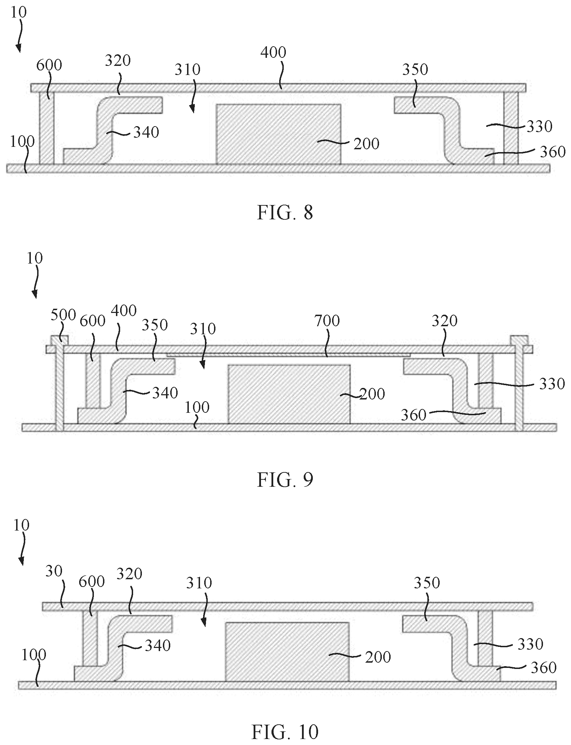

As shown in FIG. 7 and FIG. 8, in some embodiments, the circuit board assembly may further include an elastic shielding member 600. The elastic shielding member 600 is disposed on an outer peripheral side of the shielding structure 300, one end of the elastic shielding member 600 is connected to the circuit board 100 or the shielding structure 300, and the other end of the elastic shielding member 600 is pressed tightly on the heat dissipation structure 400.

In some embodiments, one end of the elastic shielding member 600 can be connected to the shielding structure 300, and the other end of the elastic shielding member 600 can be pressed tightly against the heat dissipation structure 400. In another implementation, one end of the elastic shielding member 600 can be connected to the circuit board 100, and the other end of the elastic shielding member 600 can be pressed tightly against the heat dissipation structure 400.

It may be understood that when there is a first spacing 320 between the heat dissipation structure 400 and the shielding structure 300, electromagnetic wave leakage occurs at the first spacing 320, thereby affecting electromagnetic shielding performance of the shielding cover formed by the heat dissipation structure 400 and the shielding structure 300. Alternatively, when the heat dissipation structure 400 is connected to the shielding structure 300, if the connection is not properly processed, for example, the heat dissipation structure 400 and the shielding structure 300 are not connected by using a conductive adhesive or through welding, electromagnetic wave leakage is also generated, thereby also affecting electromagnetic shielding performance of the shielding cover.

The circuit board assembly may include the elastic shielding member 600, the elastic shielding member 600 is disposed on the outer peripheral side of the shielding structure 300, and the one end that is of the shielding structure 300 and that faces away from the circuit board 100 is pressed tightly against the heat dissipation structure 400, so that the first spacing 320 between the heat dissipation structure 400 and the shielding structure 300 can be closed, an electromagnetic wave emitted by the electronic component 200 in the shielding structure 300 is prevented from leaking from the first spacing 320, and a shielding effect of the shielding cover formed by the shielding structure 300 and the heat dissipation structure 400 is improved.

In some embodiments, the elastic shielding member 600 can be connected to the heat dissipation structure 400 through bonding, or the elastic shielding member 600 can further come into contact with the heat dissipation structure 400 through abutting.

In a possible implementation, in a thickness direction of the circuit board 100, when the heat dissipation structure 400 is pressed tightly against the elastic shielding member 600, a height of the elastic shielding member 600 is greater than a height of the shielding structure 300. In the thickness direction of the circuit board 100, a compression amount of the elastic shielding member 600 is greater than or equal to 40%. It may be understood that, in a process of assembling the heat dissipation structure 400 and the elastic shielding member 600, the heat dissipation structure 400 exerts a squeezing force toward the circuit board 100 to the elastic shielding member 600, so that the elastic shielding member 600 can be compressed and deformed in the thickness direction of the circuit board 100.

A height of the elastic shielding member 600 is greater than a height of the shielding structure 300, so that when the heat dissipation structure 400 and the elastic shielding member 600 are pressed tightly, the first spacing 320 is formed while the elastic shielding member 600 can generate a compression amount.

After the heat dissipation structure 400 and the elastic shielding member 600 are pressed tightly, the elastic shielding member 600 may have an elastic recovery force after being pressed, and the heat dissipation structure 400 is pressed tightly under an action of the elastic recovery force, thereby improving contact tightness between the heat dissipation structure 400 and the elastic shielding member 600, and further improving a shielding effect of the shielding cover.

If the compression amount of the elastic shielding member 600 is excessively small, for example, the compression amount of the elastic shielding member 600 is 30%, contact tightness between the elastic shielding member 600 and the heat dissipation structure 400 is relatively poor because the elastic recovery force generated after the elastic shielding member 600 is compressed and deformed is relatively small, and an electromagnetic wave is further leaked from contact between the elastic shielding member 600 and the heat dissipation structure 400, thereby reducing a shielding effect of the shielding cover.

As shown in FIG. 7, in some embodiments, a second spacing 330 may exist between the elastic shielding member 600 and the shielding structure 300. The elastic shielding member 600 is spaced apart from the shielding structure 300 on an outer peripheral side of the shielding structure 300.

The second spacing 330 is provided between the elastic shielding member 600 and the shielding structure 300, so that the elastic shielding member 600 can be easily disassembled and maintained.

In addition, the second spacing 330 is provided, so that a probability that the shielding structure 300 is deformed because the shielding structure 300 is squeezed because the elastic shielding member 600 is tilted toward the shielding structure 300 in a compression deformation process can be avoided, thereby further reducing a probability that the electronic component 200 is damaged or a shielding effect is affected due to deformation of the shielding structure 300, and improving use stability of the circuit board assembly.

In a possible implementation, the elastic shielding member 600 is an elastic shielding member 600 prepared by using conductive foam. The conductive foam includes a main foam body and a conductive layer wrapping an outer surface of the main foam body. The conductive layer may be a conductive metal layer.

The elastic shielding member 600 is set to the elastic shielding member 600 prepared by using the conductive foam. Because the conductive foam may have good electrical conductivity, an electromagnetic wave at the first spacing 320 can be effectively shielded, electromagnetic wave leakage at the first spacing 320 is reduced, and an anti-interference capability of the electronic component 200 is improved.

In addition, the conductive foam may have softness and elasticity, and can provide a good buffering and protection effect, so that the shielding structure 300 and the electronic component 200 are less affected by vibration and a shock that are generated when the heat dissipation structure 400 is subject to an impact.

In addition, the conductive foam may have relatively good thermal conductivity, thereby facilitating transmission and dissipation of heat generated by the electronic component 200 during operation, and helping maintain operating stability of the electronic component 200.

The conductive foam may have good processability and cutting performance, and can be customized as required. The conductive foam is applicable to assembly requirements of various shapes and sizes, thereby improving processing flexibility and practicability of the elastic shielding member 600 and reducing manufacturing costs of an elastic conductive member.

In some embodiments, the elastic shielding member 600 may be an elastic shielding member 600 of a frame structure. The frame structure is sleeved on the outer peripheral side of the shielding structure 300. The elastic shielding member 600 of the frame structure includes a main foam body of the frame structure and a conductive layer that completely wraps the outer surface of the main foam body.

In a possible implementation, the elastic shielding member 600 may be formed by splicing a plurality of strip-shaped conductive foams. Head ends and tail ends of the plurality of strip-shaped conductive foams overlap with each other to form a frame-shaped elastic shielding member 600, and the frame-shaped elastic shielding member 600 surrounds the outer peripheral side of the shielding structure 300.

An inner portion of the strip-shaped conductive foam is a main foam body, and an outer peripheral surface in a length direction of the main foam body is wrapped by a conductive layer, and two ends of the strip-shaped conductive foam in an axial direction are not wrapped by the conductive layer. The head ends and the tail ends of the plurality of strip-shaped conductive foams are connected in an overlapping manner, so that an electromagnetic shielding effect of the elastic shielding member 600 can be prevented from being deteriorated because there are no conductive layers at two ends of the strip-shaped conductive foam in an axial direction during formation of the frame-shaped elastic shielding member 600.

As shown in FIG. 9, in some embodiments, the circuit board assembly may further include an insulation layer 700. The insulation layer 700 is disposed on a side that is of the heat dissipation structure 400 and that faces the electronic component 200, and at least a part of the insulation layer 700 covers the through opening 310.

The circuit board assembly may include the insulation layer 700, the insulation layer 700 is disposed on the side that is of the heat dissipation structure 400 and that faces the electronic component 200, and at least the part of the insulation layer 700 covers the through opening 310, so that electrical contact between the heat dissipation structure 400 and the electronic component 200 can be avoided, and operating stability of the electronic component 200 is improved.

In some embodiments, the insulation layer 700 can be disposed, through attachment, on a side that is of the heat dissipation structure 400 and that faces the through opening 310. For example, the insulation layer 700 can be attached to a surface of the heat dissipation structure 400 by using an adhesive. The insulation layer 700 may further be disposed, through spraying, on the side that is of the heat dissipation structure 400 and that faces the through opening 310. For example, insulation paint may be directly sprayed on the heat dissipation structure 400 as the insulation layer 700.

In a possible implementation, the insulation layer 700 is a polyethylene terephthalate (polyethylene terephthalate, PET) layer or a polyimide (polyimide, PI) layer.

The insulation layer 700 is set to the polyethylene terephthalate layer or the polyimide layer, so that an insulation effect between the heat dissipation structure 400 and the electronic component 200 can be improved, electrical contact between the heat dissipation structure 400 and the electronic component 200 can be avoided, and operating stability of the electronic component 200 can be improved.

During specific implementation, the insulation layer 700 may be polyimide, and the polyimide has high temperature resistance performance. The polyimide can withstand a high temperature of over 400°C, and a temperature range during long-term use is greater than or equal to -200°C and less than or equal to 300°C. The polyimide has a high insulation property, and a dielectric constant of the polyimide is 4.0 at 103 Hz. The insulation layer 700 is set to the polyimide, so that thermal conductivity of the heat dissipation structure 400 can be improved, to accelerate heat dissipation of the electronic component 200.

As shown in FIG. 7 and FIG. 9, in some embodiments, the shielding structure 300 may include a shielding frame 340, the shielding frame 340 may have a through opening 310, the shielding frame 340 surrounds an outer peripheral side of the electronic component 200, the shielding frame 340 is connected to the circuit board 100, and the heat dissipation structure 400 covers the through opening 310.

The shielding structure 300 may include the shielding frame 340, and the shielding frame 340 is disposed on the outer peripheral side of the electronic component 200, to perform electromagnetic shielding on the electronic component 200 on the peripheral side of the electronic component 200, and to perform electromagnetic shielding on the electronic component 200 at the through opening 310 by using a part of the heat dissipation structure 400.

As shown in FIG. 7 and FIG. 9, in some embodiments, a first flange 350 may exist on a side that is of the shielding frame 340 and that faces the circuit board 100, the first flange 350 surrounds an outer peripheral side of the shielding frame 340, the shielding frame 340 is connected to the circuit board 100 through the first flange 350, and a surface that is of the first flange 350 and that faces the circuit board 100 is used to connect to the circuit board 100.

The first flange 350 provided on the outer peripheral side of the shielding frame 340 is provided on the side that is of the shielding frame 340 and that faces the circuit board 100, and the shielding frame 340 is connected to the circuit board 100 through the first flange 350, so that a contact area between the shielding frame 340 and the circuit board 100 can be increased, thereby improving stability of a connection between the shielding frame 340 and the circuit board 100.

In some embodiments, the first flange 350 can be connected to the circuit board 100 by using a connector, and the first flange 350 can further be connected to the circuit board 100 by using a conductive adhesive, or the first flange 350 can be directly welded onto the circuit board 100.

Compared with that the first flange 350 is connected to the circuit board 100 by using the connector or the conductive adhesive, the first flange 350 is welded to the circuit board 100 through welding, so that stability of a connection between the first flange 350 and the circuit board 100 can be improved, and an electromagnetic wave can be prevented from leaking through the connection between the first flange 350 and the circuit board 100. On the basis of improving stability of the connection between the shielding frame 340 and the circuit board 100, electromagnetic shielding performance can further be improved.

Still as shown in FIG. 7 and FIG. 9, in some embodiments, a second flange 360 is provided at an end that is of the shielding frame 340 and that faces away from the circuit board 100, and an inner edge of the second flange 360 encloses the through opening 310.

The second flange 360 is provided at the end that is of the shielding frame 340 and that faces away from the circuit board 100, and the inner edge of the second flange 360 encloses the through opening 310, so that when the heat dissipation structure 400 is subject to an impact toward the shielding structure 300, the heat dissipation structure 400 comes into contact with the shielding frame 340 through the second flange 360, thereby increasing a contact area between the heat dissipation structure 400 and the shielding frame 340, reducing damage to the heat dissipation structure 400 caused by the shielding frame 340 due to an excessively small contact area between the heat dissipation structure 400 and the shielding frame 340 and excessively high pressure intensity used when the shielding frame 340 comes into contact with a heat dissipation mechanism, and prolonging a service life of the heat dissipation structure 400.

In a possible implementation, when a heat dissipation requirement of the electronic component 200 of the electronic device is relatively low, heat can be dissipated directly by using the rear housing 30 of the electronic device, and no additional heat dissipation structure 400 needs to be disposed. Because a thickness of the heat dissipation structure 400 is omitted, a thickness of the electronic device can further be reduced.

As shown in FIG. 10, this application further provides an electronic device. The electronic device may include a rear housing 30, a circuit board 100, an electronic component 200, and a shielding structure 300. The electronic component 200 is disposed on the circuit board 100, the shielding structure 300 is disposed on the circuit board 100, a through opening 310 is provided at a position that is on the shielding structure 300 and that is opposite to the circuit board 100, and at least a part of the rear housing 30 covers the through opening 310. A part of the rear housing 30 and the shielding structure 300 form a shielding cover, and the shielding cover covers the electronic component 200.

It may be understood that the rear housing 30 may be prepared by using a conductive metal material, so that the rear housing 30 and the shielding structure 300 can form the shielding cover.

When the rear housing 30 and the shielding structure 300 form the shielding cover, the rear housing 30 can come into direct contact with a side that is of the shielding structure 300 and that faces away from the circuit board 100, or a spacing can be provided between the rear housing 30 and the shielding structure 300, so that the rear housing 30 does not come into direct contact with the shielding structure 300. Buffer space is formed by using the spacing. When the rear housing 30 is subject to an impact, an impact force is directly transmitted to the shielding structure 300, thereby reducing a probability that the shielding structure 300 is damaged.

The through opening 310 is disposed at the position that is on the shielding structure 300 and that is opposite to the circuit board 100, so that a part of the electronic component 200 can extend into the through opening 310, and when a height of the electronic component 200 is increased, a height of the shielding cover does not need to be increased. In addition, a part of the rear housing 30 is used to cover the through opening 310 on the shielding structure 300, so that a part of the rear housing 30 and the shielding structure 300 jointly form the shielding cover to cover the electronic component 200, and using another shielding member to cover the through opening 310 can be avoided. In this case, a distance between the through opening 310 and the rear housing 30 can be reduced, thereby further reducing internal space of the electronic device occupied by the circuit board 100, the electronic component 200, the shielding structure 300, and the like, and facilitating further thinning of the electronic device.

As shown in FIG. 10, in some embodiments, the electronic device may further include an elastic shielding member 600. The elastic shielding member 600 is disposed on an outer peripheral side of the shielding structure 300, one end of the elastic shielding member 600 is connected to the circuit board 100 or the shielding frame 340, and the other end of the elastic shielding member 600 is pressed tightly against an inner wall of the rear housing 30.

The elastic shielding member 600 is disposed on the outer peripheral side of the shielding structure 300, so that the one end of the elastic shielding member 600 is connected to the circuit board 100 or the shielding frame 340, and the other end of the elastic shielding member 600 is pressed tightly against the inner wall of the rear housing 30, so that an electromagnetic wave leaked from a gap between the rear housing 30 and the shielding structure 300 can be shielded by using the elastic shielding member 600, thereby improving shielding performance of the shielding cover.

In some embodiments, in a thickness direction of the circuit board 100, when the heat dissipation structure 400 is pressed tightly against the elastic shielding member 600, a height of the elastic shielding member 600 is greater than a height of the shielding structure 300; and in the thickness direction of the circuit board 100, a compression amount of the elastic shielding member 600 is greater than or equal to 40%.

The height of the elastic shielding member 600 is greater than the height of the shielding structure 300, so that when the rear housing 30 and the elastic shielding member 600 are pressed tightly, the elastic shielding member 600 can generate the compression amount, and the elastic shielding member 600 can have an elastic recovery force after being pressed, and is pressed tightly against the rear housing 30 under an action of the elastic recovery force, thereby improving contact tightness between the rear housing 30 and the elastic shielding member 600, and improving a shielding effect of the shielding cover.

As shown in FIG. 10, in some embodiments, a second spacing 330 may exist between the elastic shielding member 600 and the shielding frame 340.

The second spacing 330 is provided between the elastic shielding member 600 and the shielding structure 300, so that the elastic shielding member 600 can be easily disassembled and maintained.

In addition, the second spacing 330 is provided, so that a probability that the shielding structure 300 is deformed because the shielding structure 300 is squeezed because the elastic shielding member 600 is tilted toward the shielding structure 300 in a compression deformation process can be avoided, thereby further reducing a probability that the electronic component 200 is damaged or a shielding effect is affected due to deformation of the shielding structure 300, and improving use stability of the electronic device.

In some embodiments, the elastic shielding member 600 is an elastic shielding member 600 prepared by using conductive foam.

The elastic shielding member 600 is set to the elastic shielding member 600 prepared by using the conductive foam. Because the conductive foam may have good electrical conductivity, an electromagnetic wave at the first spacing 320 can be effectively shielded, electromagnetic wave leakage at the first spacing 320 is reduced, and an anti-interference capability of the electronic component 200 is improved.

Embodiments or implementations in this specification are all described in a progressive manner. Each embodiment focuses on a difference from other embodiments. The same or similar parts between the embodiments can be referred to each other.

Generally, terms should be understood at least in part by their use in context. For example, at least in part, according to the context, the term "one or more" used in this specification may be used to describe any feature, structure, or characteristic of a singular meaning, or may be used to describe a feature, structure, or a combination of features of a complex meaning. Similarly, terms such as "a" or "the" may also be understood, at least in part, according to the context, as conveying singular or plural use.

It should be readily understood that the terms "on", "above", and "on top of" in the present disclosure should be interpreted in the broadest possible sense, such that "on" means not only "directly on something", but also "above something" with an intermediate feature or layer therebetween, and that "above" or "on top of" means not only "above something " or "on top of something", but also "above something " or "on top of something" without an intermediate feature or layer therebetween (that is, directly on something).

In addition, for ease of description, spatial relative terms may be used in the specification, such as "under", "beneath", "below", "on", and "above", to describe a relationship shown in the figure between an element or a feature and another element or feature. The term spatial relative is intended to include different orientations of devices in use or operation in addition to the orientations shown in the accompanying drawings. The apparatus may have other orientations (rotating by 90 degrees or in other orientations), and the spatial relative descriptors used herein may also be explained accordingly.

Finally, it should be noted that the foregoing embodiments are merely intended for describing the technical solutions of this application other than limiting this application. Although this application is described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of embodiments of this application.

## Claims

1. A circuit board assembly, comprising a circuit board, an electronic component, a shielding structure, and a heat dissipation structure, wherein
the electronic component is disposed on the circuit board;
the shielding structure is disposed on the circuit board, and a through opening is provided at a position that is on the shielding structure and that is opposite to the circuit board; and
at least a part of the heat dissipation structure covers the through opening, the heat dissipation structure and the shielding structure form a shielding cover, and the shielding cover covers the electronic component.

2. The circuit board assembly according to claim 1, wherein the heat dissipation structure comprises a metal housing and a heat dissipation medium disposed in the metal housing, at least a part of the metal housing covers the through opening, and the metal housing and the shielding structure form the shielding cover.

3. The circuit board assembly according to claim 1, wherein the heat dissipation structure is a vapor chamber heat dissipator or a liquid-cooling heat dissipator.

4. The circuit board assembly according to claim 1, wherein a first spacing exists between the heat dissipation structure and an end that is of the shielding structure and that faces away from the circuit board.

5. The circuit board assembly according to claim 4, wherein the first spacing is greater than 0 mm and less than or equal to 0.05 mm.

6. The circuit board assembly according to claim 1, wherein the heat dissipation structure is connected to the circuit board through a fastener.

7. The circuit board assembly according to claim 1, wherein the circuit board assembly further comprises an elastic shielding member, the elastic shielding member is disposed on an outer peripheral side of the shielding structure, one end of the elastic shielding member is connected to the circuit board or the shielding structure, and the other end of the elastic shielding member is pressed tightly against the heat dissipation structure.

8. The circuit board assembly according to claim 7, wherein in a thickness direction of the circuit board, a height of the elastic shielding member is greater than a height of the shielding structure; and
in the thickness direction of the circuit board, a compression amount of the elastic shielding member is greater than or equal to 40%.

9. The circuit board assembly according to claim 7, wherein a second spacing exists between the elastic shielding member and the shielding structure.

10. The circuit board assembly according to claim 7, wherein the elastic shielding member is an elastic shielding member prepared by using conductive foam.

11. The circuit board assembly according to any one of claims 1 to 10, wherein the circuit board assembly further comprises an insulation layer, the insulation layer is disposed on a side that is of the heat dissipation structure and that faces the electronic component, and at least a part of the insulation layer covers the through opening.

12. The circuit board assembly according to claim 11, wherein the insulation layer is a polyethylene terephthalate layer or a polyimide layer.

13. The circuit board assembly according to any one of claims 1 to 10, wherein the shielding structure comprises a shielding frame, the shielding frame has the through opening, the shielding frame surrounds an outer peripheral side of the electronic component, the shielding frame is connected to the circuit board, and the heat dissipation structure covers the through opening.

14. The circuit board assembly according to claim 13, wherein a side that is of the shielding frame and that faces the circuit board is provided with a first flange, the first flange surrounds an outer peripheral side of the shielding frame, and the shielding frame is connected to the circuit board through the first flange.

15. The circuit board assembly according to claim 13, wherein an end that is of the shielding frame and that faces away from the circuit board is provided with a second flange, and an inner edge of the second flange encloses the through opening.

16. An electronic device, comprising a rear housing and the circuit board assembly according to any one of claims 1 to 15, wherein
the circuit board assembly is disposed in the rear housing; and the heat dissipation structure in the circuit board assembly is connected to the circuit board in the circuit board assembly through the fastener; or
the heat dissipation structure is connected to the rear housing; or
the heat dissipation structure is connected to both the rear housing and the circuit board.

17. An electronic device, comprising a rear housing, a circuit board, an electronic component, and a shielding structure, wherein
the electronic component is disposed on the circuit board;
the shielding structure is disposed on the circuit board, and a through opening is provided at a position that is on the shielding structure and that is opposite to the circuit board; and
a part of the rear housing covers the through opening, the part of the rear housing and the shielding structure form a shielding cover, and the shielding cover covers the electronic component.

18. The electronic device according to claim 17, wherein the electronic device further comprises an elastic shielding member, the elastic shielding member is disposed on an outer peripheral side of the shielding structure, one end of the elastic shielding member is connected to the circuit board or the shielding structure, and the other end of the elastic shielding member is pressed tightly against an inner wall of the rear housing.

19. The electronic device according to claim 18, wherein in a thickness direction of the circuit board, a height of the elastic shielding member is greater than a height of the shielding structure; and
in the thickness direction of the circuit board, a compression amount of the elastic shielding member is greater than or equal to 40%.

20. The electronic device according to claim 19, wherein a second spacing exists between the elastic shielding member and the shielding structure.

21. The electronic device according to claim 20, wherein the elastic shielding member is an elastic shielding member prepared by using conductive foam.
